# EUROPEAN PATENT APPLICATION

(11) **EP 0 782 196 A1**
(43) Date of publication of application: **02.07.1997**
(21) Application number: 95830544.3
(22) Date of filing: 28.12.1995
(51) Int. Cl.: H01L 27/115, H01L 21/8247

(54) **Method of fabricating EEPROM memory devices and EEPROM memory device so formed**

(71) Applicant: SGS-THOMSON MICROELECTRONICS s.r.l., 20041 Agrate Brianza (Milano) (IT)
(72) Inventor: Vajana, Bruno, I-24100 Bergamo (IT)
(74) Representative: Cerbaro, Elena

(57) **Abstract**

The method includes the steps of growing, astride the surface (15) of a P-type substrate (10), thick field oxide regions (54) delimiting an active area having a width; depositing a thick gate oxide layer (42) on the substrate; forming, over the gate oxide layer, a tunnel mask (59) of photoresist material having a window of a width at least equal to that of the active area; removing the exposed portion of the gate oxide layer; implanting (65) N-type doping species into the substrate through the tunnel mask window to form a continuity region (56); growing a thin tunnel oxide region (55) on the substrate, at the tunnel mask window; depositing a first and second polysilicon layers separated by a dielectric layer; self-align patterning floating gate, control gate and gate oxide regions and one side of the tunnel oxide region; and forming N-type source and drain regions offset laterally in relation to the gate regions; the drain region (13) of the cell overlapping the continuity region (56).

## Description

The present invention relates to a method of fabricating EEPROM memory devices, and to an EEPROM memory device so formed.

As is known, a market demand exists for increasingly larger EEPROM memories (> 256 Kb), which means a corresponding reduction in cell size.

In the case of EEPROM memories with a double polysilicon level and a floating gate (so-called FLOTOX memories), which are now the most commonly used by major world producers, the mask aligning method has been found to be the main size reducing obstacle.

EEPROM memories - which are programmed by the passage of electric charges to a floating gate region by tunneling through a thin oxide region (Fowler-Nordheim current) - comprise a thin oxide region (tunnel oxide) surrounded by a thicker oxide region (gate oxide) between the floating gate region and the substrate. The thin oxide region permits passage of the Fowler-Nordheim current to program the cell, while the thicker gate oxide layer provides for increasing the coupling coefficient of the floating gate and overlying control gate (which also depends on parasitic capacitances such as that between the floating gate and substrate, and hence on the thickness of the gate oxide), and for reducing any undesired parasitic phenomena such as band-to-band tunneling (i.e. the presence of parasitic currents due to charges passing directly from the valence band to the silicon conducting band).

EEPROM memories also require an implanted region (normally implanted with phosphorous for N-channel cells) beneath and to the side of the tunnel oxide region, partially superposed to the drain region of the cell to ensure electric continuity between the substrate region beneath the tunnel oxide (tunnel area) and the drain region of the cell. The implanted region must also extend a fair way over the tunnel area to permit generation of the tunnel current, but must not extend too far beneath the gate oxide towards the source region to prevent excessively reducing the actual length of the channel region (sensing transistor of the cell).

As such, the tunnel oxide and implanted regions are formed using two masks respectively defining the tunnel oxide area and the heavy (capacitor) implant area.

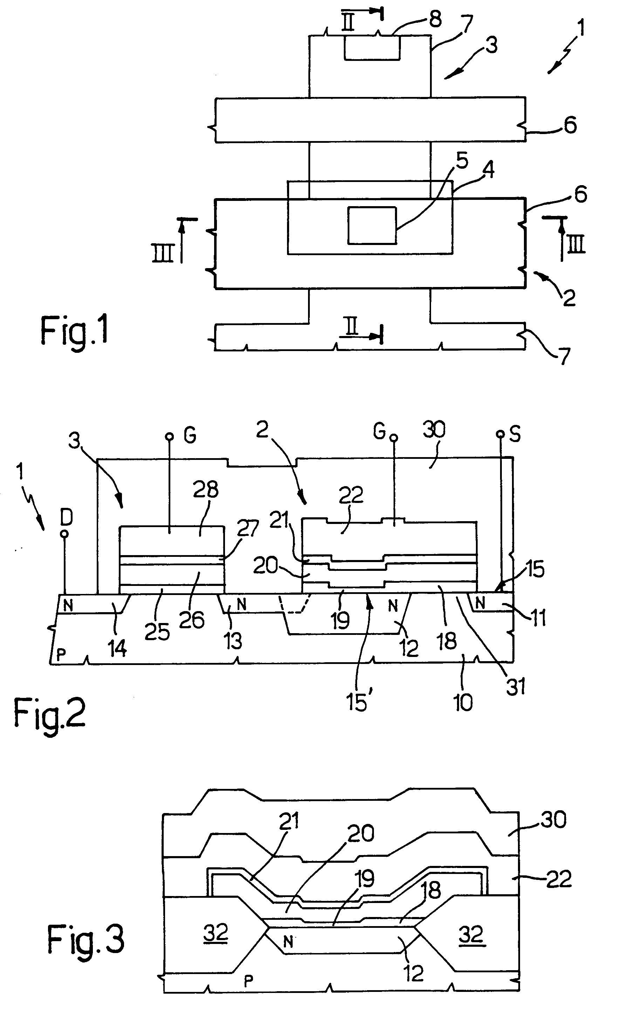

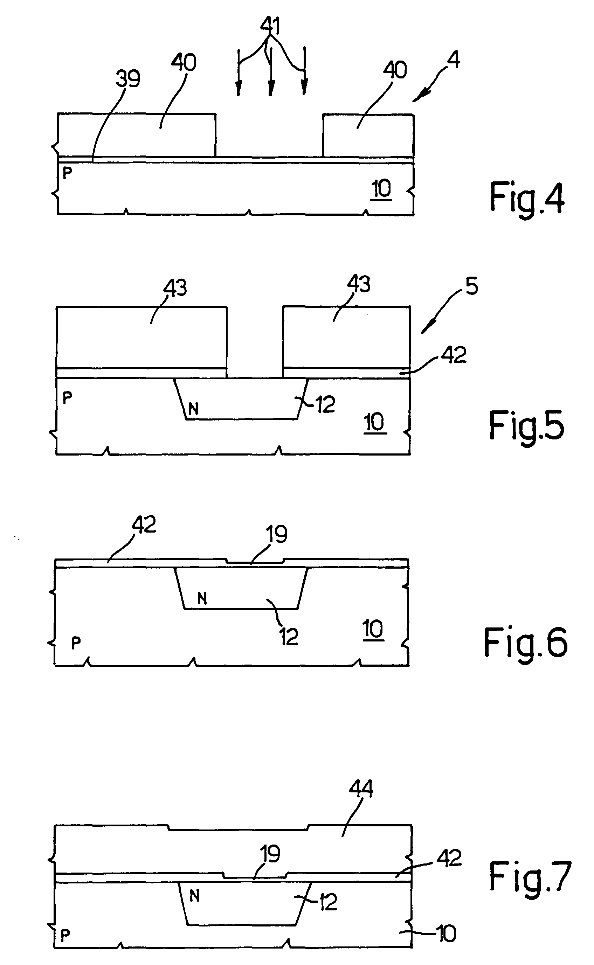

It is these two masks and the need for aligning them lengthwise of the cell and perpendicularly to the length of the cell that prevent a reduction in cell size, as explained below with reference to Figures 1-3 showing a known EEPROM cell, and Figures 4-7 showing the known method of fabricating it.

Figures 2 and 3 show a portion of a known memory device 1 comprising a cell 2 and a selection transistor 3. Number 10 in Figures 2 and 3 indicates the P-type substrate of device 1, which is formed, using the twin tub method or not, inside a semiconductor wafer of monocrystalline material. Substrate 10 houses an N-type source region 11 of cell 2, an N-type implanted electric continuity region 12, an N-type drain/source region 13 defining the drain region of cell 2 and the source region of selection transistor 3, and an N-type drain region 14 for selection transistor 3. All of regions 11-14 face the surface 15 of substrate 10.

Stacked on surface 15 are: a gate oxide region 18 of cell 2, incorporating a thin tunnel oxide region 19; a first portion 20 of a first polycrystalline silicon layer (poly1) forming the floating gate of cell 2; a first portion 21 of an interpoly dielectric layer; and a first portion 22 of a second polycrystalline silicon layer (poly2) forming the control gate region of cell 3. Also stacked on surface 15 are: a gate oxide region 25 of selection transistor 2; a second portion 26 of poly1; a second portion 27 of the interpoly dielectric layer; and a second portion 28 of poly2. An intermediate dielectric layer 30 covers the structure and insulates the various layers.

As shown in the Figure 3 section, the floating gate region (portion 20 of poly1) is insulated and surrounded at the top and laterally by interpoly dielectric layer 21 (preferably an ONO layer formed of superimposed silicon Oxide-silicon Nitride-silicon Oxide) and at the bottom by gate oxide 19 and tunnel oxide 18 of cell 2; whereas portions 26 and 28 of poly1 and poly2 of selection transistor 3 are shorted (in a not shown way) at the memory circuitry (not shown), upstream and downstream from the Figure 2 section.

Portion 15' of surface 15 beneath tunnel oxide region 19 forms the tunnel area; the distance between floating gate region 20 and surface 15 is minimum (about 80 Å) at portion 15', and is greater (about 200 Å) at gate oxide 18; and the substrate portion 31 between continuity region 12 and source region 11 forms the channel of cell 2.

As shown in Figure 3, electric continuity region 12 and channel region 31 (not visible in the Figure 3 section) are delimited laterally, widthwise, by a thick field oxide layer 32.

Device 1 is formed using the masks in Figure 1, which shows a capacitor implant mask 4; a tunnel mask 5; a self-aligned etching mask 6 (explained below); an active area mask 7 (also corresponding to the source/drain implant of cell 2 and selection transistor 3); and a mask 8 for forming drain contact D.

Device 1 is fabricated using a typical CMOS (twin or single tub) process whereby, starting from P-type substrate 10 and using nitride active area mask 7 covering the active area of cell 2 and transistor 3, field oxide layer 32 (Figure 3) defining the active areas of device 1 is grown; a sacrifical oxide layer 39 is grown; capacitor implant mask 4 is formed comprising a layer 40 of photoresist material covering the whole of gate oxide layer 42 except for a window as shown in Figure 4; the implant, shown schematically in Figure 4 by arrows 41, is made through sacrifical layer 39 to form continuity region 12; mask 40 and layer 39 are removed; a gate oxide layer 42 (Figure 5) is deposited (to form gate region 18 of cell 2 and the gate oxide layer of selection transistor 3); tunnel mask 5 is deposited comprising a layer 43 of photoresist material covering the whole of gate oxide layer 42 except for a window (Figure 5) where tunnel region 19 is to be formed; and dedicated etching is performed to clean surface 15, remove the exposed portion of layer 42, and obtain the intermediate structure shown in Figure 5.

Tunnel mask 5 is then removed, and tunnel oxide region 19 surrounded by gate oxide layer 42 is grown to obtain the intermediate structure shown in Figure 6.

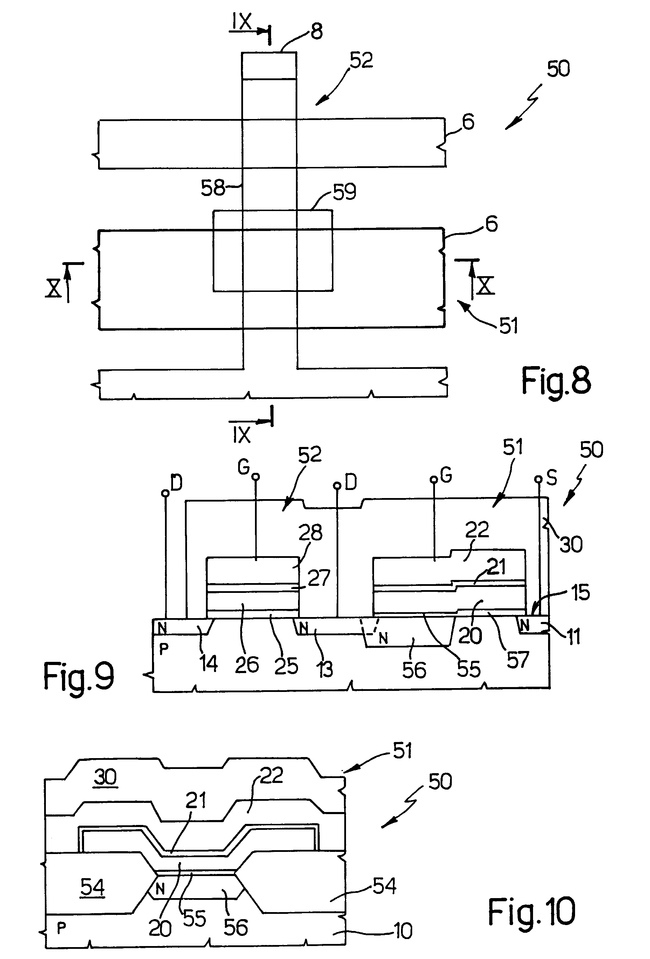

At this point, first polycrystalline silicon layer (poly1) 44 is deposited and doped (Figure 7); poly1 layer 44 is patterned to define, widthwise (horizontal direction in Figures 1 and 3), the floating gate regions 20 of the cells; the composite ONO layer is deposited; ONO layer 21 is etched at the circuit portion of device 1; the second polycrystalline silicon layer (poly2) is deposited and doped; the poly2, ONO, poly1 and gate oxide layers 42 are self-align etched using mask 6, to define, lengthwise (vertical direction in Figure 1), floating and control gate regions 20 and 22; a protective oxide layer (incorporated in dielectric layer 30 and therefore not shown) is grown over control gate regions 22; a first light drain/source implant is possibly effected; spacers (not shown) are formed to the side of the control and floating gate regions; a source/drain implant is effected to form regions 11, 13, 14 (and the structure shown in Figures 2 and 3); and the usual finish steps are performed, including forming intermediate dielectric layer 30 and the contacts, and depositing the passivation layer.

Capacitor implant mask 4, tunnel mask 5 and active area mask 7 are the cause of the aligning problems referred to previously, and prevent a reduction in cell size both in the horizontal direction (section III-III line in Figure 1) and in the vertical direction (section II-II line in Figure 1).

In fact, to ensure programming of the cell and reduce undesired parasitic phenomena, tunnel region 19 must always be fully superimposed on capacitive implant region 12 and the active region, even in the presence of misalignment and fabrication tolerances. In known devices, the first condition (superimposing the tunnel and capacitive implant regions) is met by oversizing the tunnel and capacitive implant masks in the vertical direction of line II-II in Figure 1; and the second condition (superimposing the tunnel and active regions) is met by oversizing the tunnel and active area masks in the horizontal direction of line III-III in Figure 1 (typically 0.1 µm per side for each mask, making a total of 0.4 µm per cell) thus resulting in a considerable loss in area, which is in direct contrast with the demand for smaller cells.

It is an object of the present invention to provide a fabrication method enabling a reduction in cell area.

According to the present invention, there are provided a method of fabricating EEPROM memory devices, and an EEPROM memory device so formed, as claimed respectively in Claims 1 and 11.

A preferred, non-limiting embodiment of the present invention will be described by way of example with reference to the accompanying drawings, in which:
Figure 1 shows a plan view of a number of masks used to fabricate a known EEPROM memory device;
Figure 2 shows a cross section of the known memory device along line II-II in Figure 1;
Figure 3 shows a cross section of the known memory device along line III-III in Figure 1;
Figures 4-7 show cross sections of the memory cell of the known device, as in Figure 2, at different steps in the fabrication of the cell;
Figure 8 shows a plan view of a number of masks used to fabricate one embodiment of an EEPROM memory device in accordance with the present invention;
Figure 9 shows a cross section along line IX-IX in Figure 8 of the device formed according to the invention using the Figure 8 masks;
Figure 10 shows a cross section of the Figure 9 memory device along line X-X in Figure 8;
Figures 11-13 show cross sections, similar to Figure 10, of intermediate fabrication steps;
Figures 14-17 show cross sections, similar to Figure 9, of further intermediate fabrication steps.

Figures 8-10, similar to Figures 1-3, relate to one embodiment 50 of an EEPROM memory device in accordance with the present invention, and show a portion comprising a cell 51 and a selection transistor 52, which differ from the known cell 2 and selection transistor 3 as regards the size of the active area, the size and location of the tunnel oxide region, and the form of the gate oxide region. Consequently, any parts of the device and any masks common to the known memory device 1 are indicated using the same numbering system as previously. Conversely, the field oxide regions in this case are numbered 54; the tunnel oxide region 55; the continuity region 56; the gate oxide region 57; the active area mask 58; and the tunnel mask 59.

In the embodiment shown, tunnel mask 59 is so designed that tunnel oxide 55 grows over the entire width of the active area in the portion considered; the capacitor implant is effected using tunnel mask 59, thus eliminating the special mask used in the known method; and the width of the active area is reduced to the minimum permitted by the photolithographic process.

This therefore provides for eliminating a mask and associated operations, thus improving the manufacturability and reducing the defectiveness and fabrication cost of the memory device; as well as for eliminating the alignment tolerances of the tunnel and capacitor implant masks, thus improving scalability of the cell in the vertical direction (section line IX-IX in Figure 8). Moreover, since the tunnel region need no longer also be surrounded by the gate oxide region in the Figure 10 section direction, the active area mask 7 need no longer be oversized as compared with the minimum theoretical size, and may be reduced to the minimum permitted by the lithographic process, thus achieving a considerable reduction in size in direction X-X.

Though the device so formed may, in certain conditions, present problems in terms of reliability, it may still be used to advantage in certain applications, particularly those in which size is the critical factor.

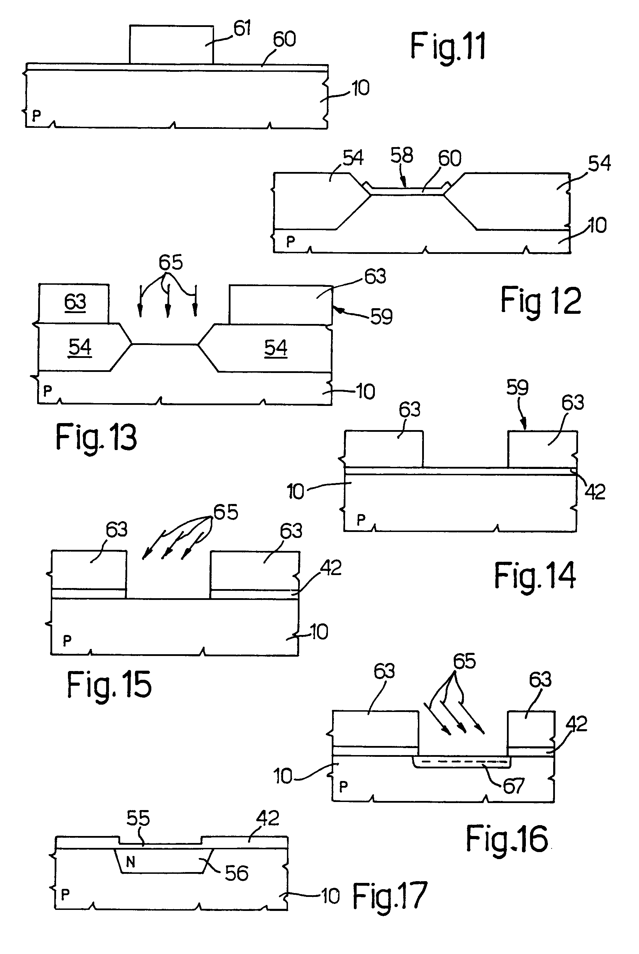

Cell 51 and selection transistor 52 are fabricated as follows. Commencing with P-type substrate 10, nitride mask 58 covering the active area is formed by depositing a nitride layer 60 on surface 15, patterning it using a photoresist mask 61 covering the nitride over the active area (as shown in the cell portion in Figure 11), and removing the exposed portion of nitride layer 60; thermal oxidation is performed to grow field oxide layer 54 with the exception of the portions covered by nitride mask 58 (Figure 12); nitride mask 58 is removed; instead of forming the capacitor implant mask as in the known method, gate oxide layer 42 of cell 51 and the gate oxide layer (not shown) of selection transistor 52 are deposited directly; and tunnel mask 59 is deposited comprising a photoresist material layer 63 covering the whole of gate oxide layer 42 with the exception of a window, as shown in Figures 13 and 14. More specifically, and as shown also in Figure 8, in the horizontal direction, the tunnel mask window extends over the full width of the active area and on to field oxide 54, and, in the vertical direction in Figure 8, extends beyond the self-align etching mask 6 and partially over the area of substrate 10 in which the drain region 13 of cell 51 is to be formed. Using mask 59, dedicated etching is performed to clean surface 15 and remove the exposed part of layer 42 (still visible in Figure 14); and the capacitors are implanted as shown by arrows 65 in Figures 13, 15 and 16. The capacitors are preferably implanted at a given tilt angle, both towards drain region 13 of the cell to assist electric continuity (Figure 15), and in the opposite direction towards source region 11 of the cell (Figure 16). Number 67 in Figure 16 indicates a thin layer in which the implanted doping species is concentrated. At this point, tunnel mask 59 is removed; tunnel oxide region 55 is grown; and the method continues with the same steps as in the known method, including: depositing, doping and patterning first polycrystalline silicon layer (poly1) 44; depositing and patterning the composite ONO layer; depositing and doping the second polycrystalline silicon layer (poly2); and self-align etching poly2, the ONO layer, poly1 and gate oxide layer 42 using mask 6. The latter step also etches part of the tunnel oxide 55 beyond mask 6, so that the lateral edge, facing selection transistor 52, of tunnel region 55 is aligned with the edge of stacked layers 20, 21, 22, and tunnel oxide region 55 is only contiguous to gate oxide region 57 on the side facing source region 11 of cell 51. This is then followed by: formation of the spacers; source/drain implanting; and the usual finish steps mentioned above.

The advantages of the method according to the present invention will be clear from the foregoing description.

Clearly, changes may be made to the fabrication method and device as described and illustrated herein without, however, departing from the scope of the present invention. In particular, the capacitor implant may be effected either before or after removing the portion of the gate oxide layer in which the tunnel oxide region is to be formed (as in the example shown).

## Claims

1. A method of fabricating EEPROM memory devices comprising a semiconductor material substrate having a surface; the method comprising the steps of:
- forming thick insulating regions onto said surface of said substrate, said insulating regions delimiting with each other an active area having a width;
- forming a tunnel insulating region; and
- forming a gate insulating region to the side of said tunnel insulating region, said tunnel and gate insulating regions extending over said active area, and said tunnel insulating region being thinner than said gate insulating region;
characterized in that said tunnel insulating region is formed over the full width of said active area.

2. A method as claimed in Claim 1, wherein said semiconductor material substrate has a first conductivity type, characterized in that it also comprises the steps of:
- forming a conducting region of a second conductivity type in said substrate; said conducting region being offset laterally in relation to said tunnel insulating region; and
- forming a continuity region of said second conductivity type in said substrate, beneath said tunnel insulating region, and in electric continuity with said conducting region;
said tunnel insulating region and said continuity region being formed using a single mask of photoresist material.

3. A method as claimed in Claim 2, characterized in that it comprises the step of depositing a gate insulating layer on said substrate;
in that said step of forming a continuity region comprises the steps of:
- depositing on said gate insulating layer a mask of photoresist material having a window; and
- implanting doping species determining said second conductivity type through said window;
and in that said step of forming a tunnel insulating region comprises the step of:
- removing an exposed portion of said gate insulating layer at said window; and
- growing said tunnel insulating region on said substrate, where said exposed portion of said gate insulating layer has been removed.

4. A method as claimed in Claim 3, characterized in that said step of removing an exposed portion is performed prior to said step of implanting doping species.

5. A method as claimed in Claim 3, characterized in that said step of removing an exposed portion is performed after said step of implanting doping species and prior to said step of growing said tunnel insulating region.

6. A method as claimed in Claim 3, characterized in that said step of implanting doping species comprises the step of tilt implanting.

7. A method as claimed in any one of the foregoing Claims from 3 to 6, characterized in that said window of said mask of photoresist material presents a width no smaller than the width of said active area, and extends, in a direction perpendicular to said width, over a portion of said substrate intended to house said conducting region.

8. A method as claimed in Claim 7, characterized in that it comprises the steps of depositing a first semiconductor material layer over said gate insulating layer and said tunnel insulating region; depositing a dielectric layer over said first semiconductor material layer; depositing a second semiconductor material layer over said dielectric layer; and self-align patterning said second semiconductor material layer, said dielectric layer, said first semiconductor material layer, said gate insulating layer and said tunnel insulating region.

9. A method as claimed in any one of the foregoing Claims from 1 to 8, characterized in that said first conductivity type is a P type, and said second conductivity type is an N type.

10. A method as claimed in any one of the foregoing Claims from 1 to 9, characterized in that said conducting region is a drain region.

11. An EEPROM memory device formed of memory cells (51) and comprising a substrate (10) of semiconductor material having a surface (15); thick oxide regions (54) extending astride said surface of said substrate and defining an active area having a width; a tunnel insulating region (55) over said substrate (10); and a gate insulating region (57) over said substrate and laterally to said tunnel insulating region (55); said tunnel insulating region being thinner than said gate insulating region; characterized in that said tunnel insulating region (55) extends over the full width of said active area.

12. A device as claimed in Claim 11, characterized in that said substrate (10) has a first conductivity type; and in that said substrate houses a conducting region (13) of a second conductivity type offset laterally in relation to said tunnel insulating region (55), and a continuity region (56) of said second conductivity type; said continuity region being located beneath said tunnel insulating region (55), in electric continuity with said conducting region (13), and aligned with said tunnel insulating region widthwise of said active area and on the opposite side to said conducting region (13).

13. A device as claimed in Claim 12, characterized in that it comprises a stack comprising a floating gate region (20) over said tunnel insulating region (55), a dielectric region (21) over said floating gate region, and a control gate region (22) over said dielectric region; and in that one side of said stack is aligned with the side of said tunnel insulating region (55) facing said conducting region (13).
